# FASCICULE DE BREVET EUROPEEN

(11) **EP 1 864 326 B1**
(45) Date de publication et mention de la délivrance du brevet: **14.11.2012**
(21) Numéro de dépôt: 06725523.2
(22) Date de dépôt: 03.04.2006
(51) Int. Cl.: H01L 23/498, H05K 3/34, H01L 25/16

(54) **MODULE ELECTRONIQUE DE FAIBLE EPAISSEUR COMPRENANT UN EMPILEMENT DE BOITIERS ELECTRONIQUES A BILLES DE CONNEXION**
ELEKTRONISCHES MODUL GERINGER DICKE MIT EINEM MIT VERBINDUNGSKUGELN AUSGESTATTETEN STAPEL ELEKTRONISCHER BAUTEILE
LOW- THICKNESS ELECTRONIC MODULE COMPRISING STACKED ELECTRONIC PACKAGES PROVIDED WITH CONNECTION BALLS

(30) Priorité: 01.04.2005 FR 0503207; 10.06.2005 FR 0505926
(43) Date de publication de la demande: 12.12.2007
(73) Titulaire: 3D Plus, 78532 Buc Cedex (FR)
(72) Inventeur: VAL, Christian, F-78470 St Rémy Lès Chevreuse (FR)
(74) Mandataire: Henriot, Marie-Pierre
(86) Numéro de dépôt international: PCT/EP2006/061281
(87) Numéro de publication internationale: WO 2006/103299

(56) Documents cités:
- EP-A2- 1 132 962
- US-A- 5 828 128
- US-A- 6 087 597
- US-A1- 2002 020 058
- US-A1- 2003 030 143
- US-A1- 2003 043 650
- US-A1- 2003 080 438
- US-B1- 6 249 131
- US-B1- 6 297 141
- PATENT ABSTRACTS OF JAPAN vol. 2000, no. 23, 10 février 2001 (2001-02-10) -& JP 2001 168511 A (TOSHIBA CORP), 22 juin 2001 (2001-06-22)
- PATENT ABSTRACTS OF JAPAN vol. 1997, no. 06, 30 juin 1997 (1997-06-30) -& JP 09 036537 A (MATSUSHITA ELECTRIC IND CO LTD), 7 février 1997 (1997-02-07)

## Description

L'invention concerne un module électronique de faible épaisseur qui comprend un empilement de boîtiers électroniques.

Ces boîtiers comportent un circuit imprimé avec au moins une puce, enrobé d'une résine protectrice et sont pourvus sur leur surface inférieure de billes de connexion. Ce sont par exemple des boîtiers de type BGA (« Ball Grid Array ») ou FBGA (« Fine Ball Grid Array »).

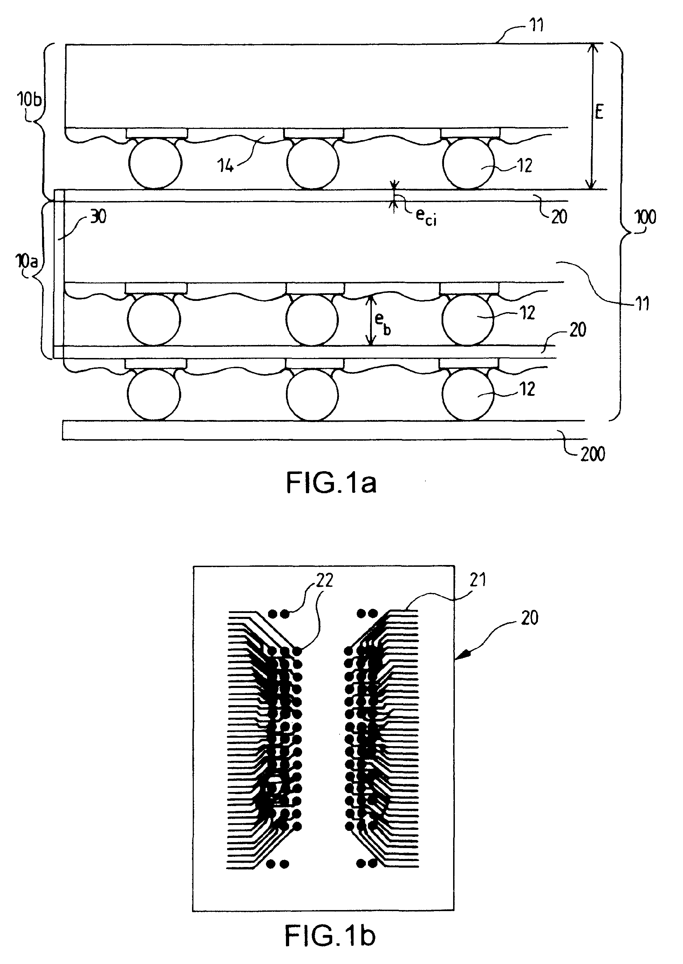

Ils sont empilés pour former un module électronique. On a représenté figure 1a vu en coupe, un module électronique 100 connu comportant 2 boîtiers 10a, 10b. Il comprend pour chaque boîtier, un circuit d'interconnexion 20 du boîtier représenté figure 1b vu de dessus, dont la surface a la même dimension que celle du boîtier, et dont les pistes 21 relient des plots 22 positionnés vis-à-vis des billes 12, aux bords du circuit. Une bande centrale sans connexions ni plots correspond à la bande centrale de la surface inférieure du boîtier qui protège des fils de cablage reliant les billes au circuit imprimé du boîtier. Ces circuits 20 sont reliés entre eux par leurs bords, en l'occurrence par un bus métallique 30 situé sur un côté du module. Des billes de connexion 12 sont disposées sous le circuit d'interconnexion inférieur 10a en prévision d'une connexion du module 100 à un substrat d'interconnexion 200. Un vernis isolant 14 est disposé sous la surface inférieure du corps 11 du boîtier.

Les documents EP1132962 et US6297141 décrivent des procédés de fabrication d'un boîtier électronique.

Le document US2003043650 décrit un module électronique comprenant un empilement de n boîtiers.

Les modules électroniques sont aujourd'hui soumis à des contraintes d'épaisseur et de surface. Aujourd'hui, un module avec 2 boîtiers ne doit pas dépasser 2.7 mm d'épaisseur, ni dépasser en surface celle d'un boîtier. Un corps 11 de boîtier a typiquement une épaisseur de 0.8 mm, un circuit imprimé d'interconnexion 20 une épaisseur de 0.15 mm et une bille de connexion 12, une épaisseur de 0.4 mm. L'épaisseur globale de 3.1 mm, dépasse alors le seuil requis.

Le but de l'invention est de proposer un module électronique respectant ces contraintes d'épaisseur et de surface.

L'invention a pour objet un module électronique selon la revendication independante 1.

De cette façon, le circuit d'interconnexion du boîtier est intégré entre les billes ; il n'ajoute donc pas d'épaisseur au boîtier et n'augmente pas non plus sa surface. L'épaisseur de chaque boîtier est ainsi diminuée de l'épaisseur du circuit imprimé de connexion.

Selon une caractéristique de l'invention, le module électronique comprend un élément latéral de connexion des circuits percés entre eux, et l'empilement présentant un boîtier inférieur et des boîtiers supérieurs, le circuit imprimé percé du boîtier inférieur comprend au moins une bille non connectée au boîtier inférieur et destinée à connecter un boîtier supérieur à un substrat d'interconnexion du module, via le circuit imprimé percé et l'élément latéral de connexion.

Selon un premier mode de réalisation de l'invention, les circuits imprimés percés sont connectés entre eux par un bus métallique.

Selon un autre mode de réalisation, au moins deux circuits imprimés percés sont connectés entre eux par un élément latéral de connexion qui forme avec ces circuits imprimés percés, un circuit souple dit « flex ».

Ce circuit « flex » peut être en accordéon.

Le module comprend avantageusement au moins un film condensateur disposé sur et/ou sous chaque boîtier.

Les percements sont de préférence sensiblement circulaires et présentent un diamètre dp supérieur ou égal au diamètre e_{b} des billes, de manière à ce que les billes traversent le circuit imprimé percé avant leur connexion, ou inférieur au diamètre e_{b} des billes de manière à moins diminuer la surface routable du circuit imprimé.

L'invention a aussi pour objet un procédé de fabrication d'un boîtier électronique selon la revendication indépendante 9.

De préférence, le circuit imprimé percé comprend au moins une bille non connectée au boîtier ou un percement brasé non connecté au boîtier.

Selon une caractéristique de l'invention, les percements sont sensiblement circulaires et présentent un diamètre dp supérieur ou égal au diamètre e_{b} des billes ou inférieur au diamètre e_{b} des billes pour les raisons invoquées précédemment.

D'autres caractéristiques et avantages de l'invention apparaîtront à la lecture de la description détaillée qui suit, faite à titre d'exemple non limitatif et en référence aux dessins annexés dans lesquels :
- les figures 1a et 1b déjà décrites représentent schématiquement un module électronique connu comportant 2 boîtiers, vu en coupe, et un circuit d'interconnexion de boîtier connu vu de dessus,
- les figures 2a et 2b représentent schématiquement un boîtier électronique selon l'invention avant connexion, vu en coupe, et un circuit d'interconnexion de boîtier selon l'invention vu de dessus,
- les figures 3a et 3b représentent schématiquement deux étapes d'un exemple d'un mode de réalisation d'un boîtier électronique selon l'invention, lorsque les trous du circuit d'interconnexion du boîtier sont plus petits que les billes, avant que les billes ne soient connectées (figure 3a) et après leur connexion (figure 3b),
- les figures 4a, 4b et 4c représentent schématiquement des exemples de forme de collerette de métallisation des trous,
- la figure 5 représente schématiquement un exemple d'un premier mode de réalisation d'un module électronique selon l'invention comportant 2 boîtiers, après connexion, vu en coupe,
- les figures 6a et 6b représentent schématiquement deux exemples d'un deuxième mode de réalisation d'un module électronique selon l'invention après connexion, vu en coupe, comportant respectivement 2 et 3 boîtiers,
- la figure 7 représente schématiquement un module électronique selon l'invention comportant 2 boîtiers, disposé sur un substrat d'interconnexion de module, après connexion.

D'une figure à l'autre, les mêmes éléments sont repérés par les mêmes références.

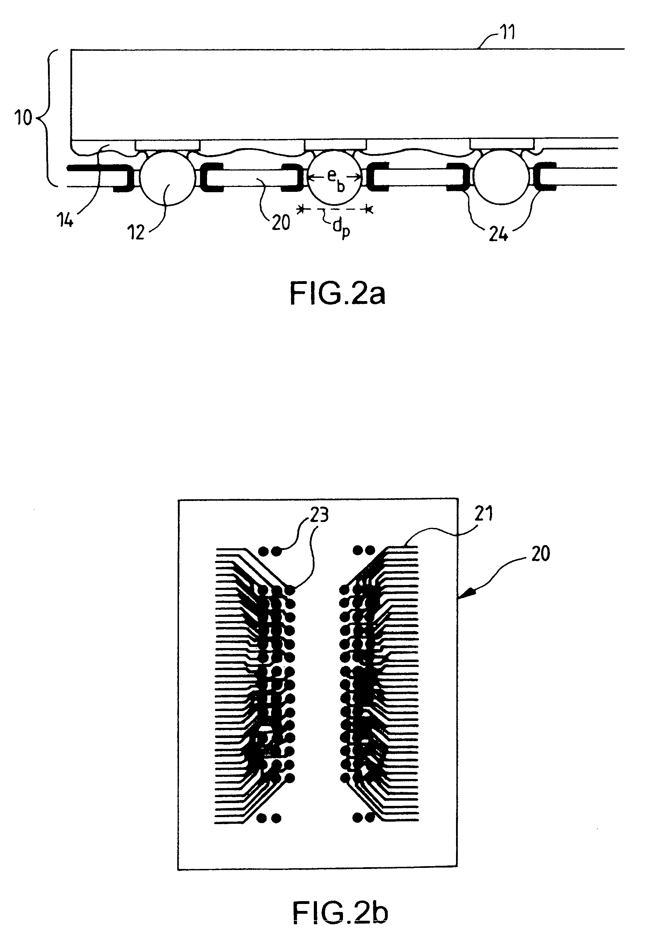

L'exemple de boîtier 10 représenté en coupe figure 2a comprend les mêmes éléments que celui décrit en relation avec la figure 1a, à savoir des billes de connexion 12 et un circuit imprimé 20 d'interconnexion du boîtier, collé sur la surface inférieure du corps 11 boîtier, en l'occurrence sur le vernis 14 au moyen d'une résine non représentée sur la figure. Selon l'invention, ce circuit 20 est percé de trous ou percements 23 représentés figure 2b ; ils sont disposés vis-à-vis des billes 12. Les plots 22 du circuit d'interconnexion de l'art antérieur, décrit en relation avec la figure 1b, sont remplacés par des trous métallisés 23.

Ces trous sont métallisés et disposent d'une collerette conductrice 24; les billes sont connectées aux trous par brasure.

Selon un premier mode de réalisation d'un boîtier illustré figure 2a, ces trous sont sensiblement circulaires de diamètre dp et sont de préférence légèrement plus grands que les billes de manière à ce que celles-ci traversent aisément le circuit avant la connexion des billes au circuit. On a dp ≥ e_{b}.

Initialement, les billes ont une épaisseur e_{b} d'environ 0.4 mm par exemple. Lors de leur connexion aux trous métallisés, l'épaisseur des billes qui gardent un volume constant diminue : elle peut alors éventuellement être compensée en apportant lors de la brasure, un supplément de matière de manière à conserver l'épaisseur initiale des billes. Les billes ont ainsi une épaisseur constante. La matière ajoutée est celle utilisée pour les billes, comme par exemple un alliage sans plomb tel que étain/cuivre/argent.

Plus les trous sont grands, plus la surface routable du circuit diminue, ce qui présente un inconvénient. Par surface routable, on entend la surface qui comprend les pistes de connexion notées 21 sur les figures 1b et 2b.

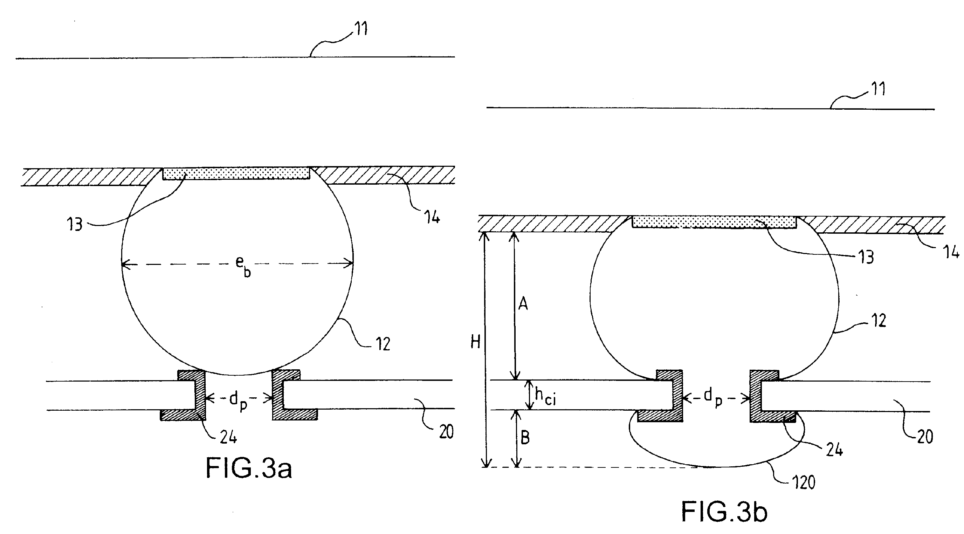

Selon un autre mode de réalisation d'un boîtier, qui permet de remédier à ce problème de surface routable diminuée, et illustré figures 3 pour une bille, les trous circulaires sont plus petits que les billes. On a dp < e_{b}. Avant la connexion des billes aux trous métallisés, le circuit percé 20 est disposé sous les billes 12 comme représenté figure 3a. Lors de la connexion des billes au circuit par brasure par exemple, les billes 12 qui se déforment par effet capillaire traversent également le circuit 20 et créent une zone hémisphérique 120 sous le circuit 20 comme représenté figure 3b. En se déformant elles attirent avec elles le corps 11 du boîtier qui « descend » : la hauteur finale H égale à celle de la bille connectée (=A+B) ajoutée à celle du circuit percé (= h_{ci}), est inférieure ou égale à l'épaisseur initiale de la bille e_{b} avec une marge de tolérance d'environ 10%. Globalement, la hauteur H est inférieure à e_{b} (1+ 10%).

On a obtenu les résultats suivants pour une épaisseur initiale de bille e_{b} de 420 µm et h_{ci} =100 µm : H=439 µm, A=244 µm, B=95 µm.

On a bien H < e_{b} (1 + 10%). L'épaisseur totale E du boîtier est par conséquent inférieure à E + 10% e_{b}.

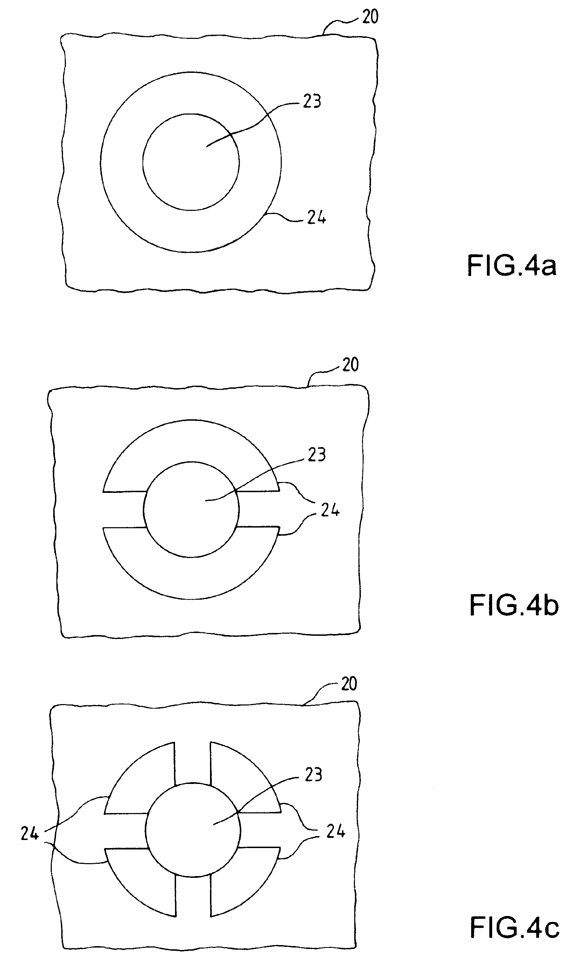

La collerette est par exemple circulaire comme représenté figure 4a ; elle peut avoir une autre forme. En effet, le second mode de réalisation du boîtier étant basé sur l'effet capillaire, celui-ci peut être accentué en choisissant une collerette en deux parties ou en quartiers de part et d'autre du trou, respectivement représentés figures 4b et 4c, ou plus généralement selon une forme comportant une partie de la collerette circulaire.

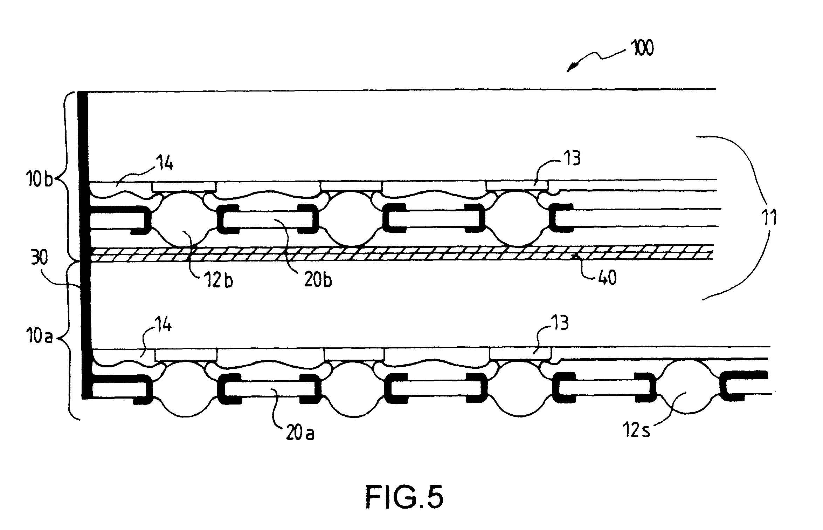

Selon un premier mode de réalisation d'un module dont un exemple avec 2 boîtiers est représenté figure 5, le module 100 selon l'invention comprend un élément latéral 30 de connexion des circuits percés entre eux, en l'occurrence un bus métallique.

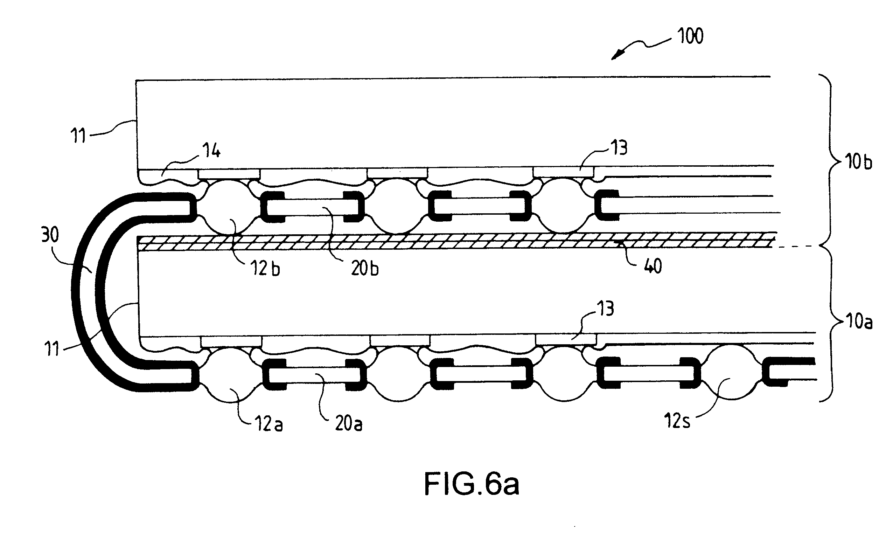

Selon un autre mode de réalisation d'un module dont un exemple avec 2 boîtiers également est représenté figure 6a, le module 100 selon l'invention comprend un élément latéral 30 de connexion des circuits percés entre eux qui forme avec ces circuits percés, un circuit souple unique dit « flex ».

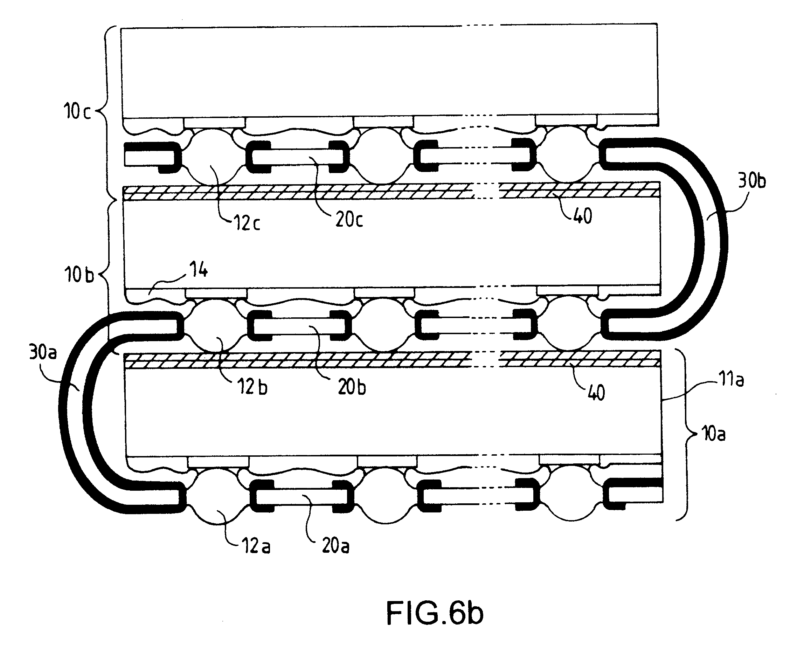

Le circuit imprimé 20 peut être en une seule partie ou en deux parties. Lorsqu'il est en deux parties, il y a alors deux circuits « flex », situés de part et d'autre du module. Lorsque le module comprend n boîtiers avec n>2, un circuit « flex » en accordéon peut alors être utilisé pour connecter successivement les n boîtiers, comme illustré figure 6b pour 3 boîtiers 10a, 10b et 10c. Le circuit « flex » est alors formé des circuits imprimés 20a, 20b et 20c et des éléments de connexion latéraux 30a et 30b.

De préférence, on dispose entre les billes et le boîtier situé sous ces billes, un film condensateur 40 de faible épaisseur (entre 2 à 80 µm) pour préserver l'intégrité des signaux transmis par les éléments de connexion. Ce film peut aussi être situé sur le boîtier de manière à disposer d'un film condensateur par boîtier. Ce film peut également être situé entre les billes 12a du boîtier inférieur et un substrat d'interconnexion du module. Finalement, ce film 40 peut être situé sur et/ou sous chaque boîtier 10 : sur la figure 6b, on a représenté un boîtier 10c avec un film 40 situé sous les billes 12c, et un boîtier 10a avec un film 40 situé sur le corps 11a du boîtier.

Le module selon l'invention est destiné à être placé sur un substrat d'interconnexion du module. Les billes du boîtier inférieur permettent de connecter le boîtier inférieur à ce substrat.

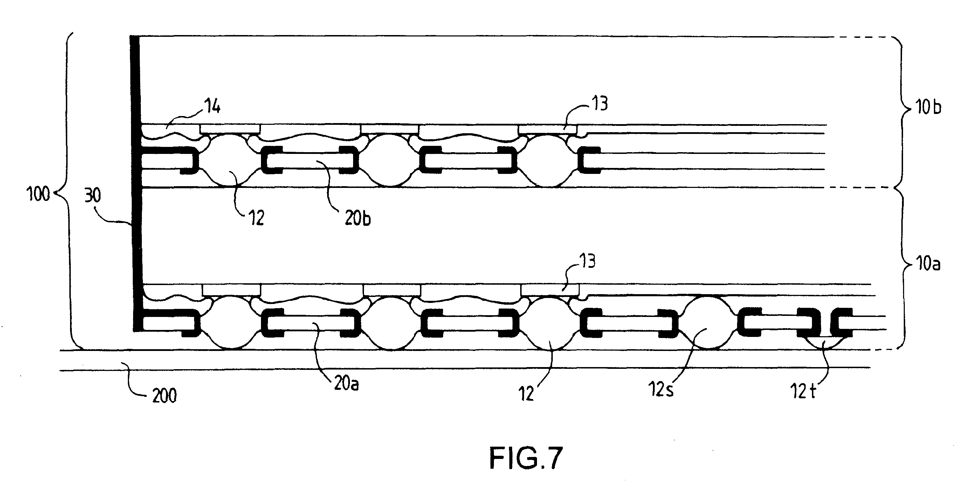

Selon l'invention, le circuit percé 20a du boîtier inférieur 10a comprend en outre, au moins une bille 12s non connectée au boîtier inférieur par un plot 13, comme indiqué figures 5, 6a et 7. Cette bille supplémentaire 12s permet de connecter le substrat 200 (figure 7) à un boîtier supérieur 10b via le circuit percé inférieur 20a et l'élément latéral de connexion 30, que celui-ci soit un bus métallique ou une partie d'un circuit « flex », ou autre. Cette bille 12s permet d'acheminer un signal de sélection tel qu'un signal « CS » (« Chip select »), ou « CKE » (« Clock Enable »), ou « ODT » (« On Die Termination »), ou tout autre signal. Lorsque plusieurs signaux doivent être adressés au même boîtier, le circuit percé inférieur compte autant de billes supplémentaires que de signaux. Ce nombre de billes est bien sûr multiplié par le nombre de boîtiers à adresser. Le circuit percé inférieur a finalement (n-1) m billes 12s en plus, n étant le nombre de boîtiers et m le nombre de signaux. Ces billes 12s peuvent être remplacées par des trous non connectés au boîtier inférieur, sans billes mais brasés avec de la brasure identique à celle des billes. Ces trous brasés 12t dont un exemple est représenté figure 7, sont de préférence plus petits que les autres trous : ils ont par exemple un diamètre d'environ 0.1 mm.

On a obtenu les résultats suivants pour un module selon le premier mode de réalisation : son épaisseur ne dépasse pas 2.4 mm (n x 1.2 mm, avec ici n=2, les billes de connexion au substrat 200 devenant inutiles) au lieu de 3.1 mm dans le cas du module de l'art antérieur; sa surface ne dépasse pas non plus celle d'un boîtier.

On a présenté des exemples avec 2 boîtiers mais le module selon l'invention peut comporter 3, 4 boîtiers voire plus.

## Revendications

1. Module électronique (100) comprenant un empilement de n boîtiers (10, 10a, 10b), n>1, chaque boîtier étant pourvu sur la surface inférieure du corps (11) du boîtier, de billes de connexion (12) et, relié aux billes, d'un circuit imprimé (20, 20a, 20b) d'interconnexion du boîtier, disposé sur la surface inférieure du corps du boîtier au niveau des billes, qui présente des percements métallisés (23) dans lesquels sont situées les billes (12) et auxquels elles sont connectées, et qui a une épaisseur inférieure à celle des billes, le module comprenant un élément latéral (30) de connexion des circuits percés entre eux, et l'empilement présentant un boîtier inférieur (10a) et des boîtiers supérieurs (10b), **caractérisé en ce que** le circuit imprimé percé (20a) du boîtier inférieur comprend au moins une bille (12s) ou un percement brasé (12t) non connecté au boîtier inférieur (10a) et destiné à connecter un boîtier supérieur (10b) à un substrat d'interconnexion (200) du module, via le circuit imprimé percé (20a) et l'élément latéral de connexion (30).

2. Module électronique selon la revendication précédente, **caractérisé en ce que** le circuit imprimé d'interconnexion du boîtier a une surface sensiblement de même dimension que celle du boîtier.

3. Module électronique selon l'une quelconque des revendications précédentes, **caractérisé en ce que** l'élément latéral est un bus métallique.

4. Module électronique selon l'une quelconque des revendications 1 à 2, **caractérisé en ce que** l'élément latéral de connexion forme avec ces circuits imprimés percés, un circuit souple dit « flex ».

5. Module électronique selon la revendication précédente, **caractérisé en ce qu'**au moins trois circuits imprimés percés sont connectés entre eux par un circuit « flex » en accordéon.

6. Module électronique selon l'une quelconque des revendications précédentes, **caractérisé en ce qu'**il comprend au moins un film condensateur (40) disposé sur et/ou sous chaque boîtier.

7. Module électronique selon l'une quelconque des revendications précédentes, **caractérisé en ce que** les percements sont métallisés selon une collerette circulaire (24a) ou en deux parties (24b) ou en quartiers (24c).

8. Module électronique selon l'une quelconque des revendications précédentes, **caractérisé en ce que** les boîtiers sont des boîtiers de type BGA ou FBGA.

9. Procédé de fabrication d'un boîtier électronique (10, 10a, 10b) qui comprend :
- un ensemble d'épaisseur E comportant un corps (11) de boîtier, pourvu sur sa surface inférieure de billes de connexion (12) d'épaisseur e_{b} pré-déterminée avant connexion,
- un circuit imprimé (20, 20a, 20b) d'interconnexion du boîtier qui a une épaisseur e_{ci} inférieure à e_{b} et qui présente des percements métallisés (23) sensiblement circulaires d'un diamètre dp supérieur ou égal au diamètre e_{b} des billes,
ledit procédé comportant une étape de connexion par brasure des billes de connexion (12) aux percements métallisés (23) du circuit de manière à ce que l'épaisseur totale du corps (11) du boîtier, des billes (12) et du circuit imprimé (20) après la connexion ne dépasse pas E+ 10% e_{b}, et en ce que les percements sont métallisés selon une collerette circulaire (24a) ou en deux parties (24b) ou en quartiers (24c).

10. Procédé de fabrication d'un boîtier électronique selon la revendication précédente, **caractérisé en ce que** le circuit imprimé d'interconnexion du boîtier a une surface sensiblement de même dimension que celle du boîtier.

11. Procédé de fabrication d'un boîtier électronique selon l'une quelconque des revendications 9 à 10, **caractérisé en ce que** le circuit imprimé percé comprend au moins une bille (12s) non connectée au boîtier ou au moins un percement brasé (12t) non connecté au boîtier.

## Claims

1. An electronic module (100) comprising a stack of n packages (10, 10a, 10b), n>1, each package being provided on the lower surface of the body (11) of the package with connection balls (12) and, connected to the balls, with a printed circuit (20, 20a, 20b) for interconnnecting the package that is disposed on the lower surface of the body of the package near the balls, which printed circuit has metallised vias (23) in which the balls (12) are located and to which they are connected, and the thickness of which is less than that of the balls, the module comprising a lateral element (30) for connecting perforated circuits together, and the stack has a lower package (10a) and upper packages (10b), **characterised in that** the perforated printed circuit (20a) of the lower package comprises at least one ball (12s) or a brazed via (12t) that is not connected to the lower package (10a) and is designed to connect an upper package (10b) to an interconnection substrate (200) of the module via the perforated printed circuit (20a) and the lateral connecting element (30).

2. The electronic module according to the preceding claim, **characterised in that** the surface of the printed interconnection circuit of the package is essentially the same size as that of the package.

3. The electronic module according to any one of the preceding claims, **characterised in that** the lateral element is a metal bus.

4. The electronic module according to one of claims 1 to 2, **characterised in that** the lateral connection element forms a flexible "flex" circuit with these perforated printed circuits.

5. The electronic module according to the preceding claim, **characterised in that** at least three perforated printed circuits are connected together by a "flex" circuit in the form of a concertina.

6. The electronic module according to any one of the preceding claims, **characterised in that** it comprises at least one capacitor film (40) disposed on and/or under each package.

7. The electronic module according to any one of the preceding claims, **characterised in that** the vias are metallised as a circular flange (24a) or in two parts (24b) or in quarters (24c).

8. The electronic module according to any one of the preceding claims, **characterised in that** the packages are packages of the BGA or FBGA type.

9. A method for manufacturing an electronic package (10, 10a, 10b) that comprises:
- an assembly of thickness E comprising a package body (11), provided on its lower surface with connection balls (12) of thickness e_{b} that is predetermined before connection;
- a printed circuit (20, 20a, 20b) for interconnecting the package, the thickness e_{ci} of which is less than e_{b}, and that has metallised vias (23) that are essentially circular with a diameter dₚ that is greater than or equal to the diameter e_{b} of the balls;
said method comprising a step of connecting the connection balls (12) to the metallised vias (23) of the circuit by brazing so that the total thickness of the body (11) of the package, the balls (12) and the printed circuit (20) after connection does not exceed E+ 10% e_{b}, and in that the vias are metallised as a circular flange (24a) or in two parts (24b) or in quarters (24c).

10. The method for manufacturing an electronic package according to the preceding claim, **characterised in that** the surface area of the printed circuit for interconnecting the package is essentially the same size as that of the package.

11. The method for manufacturing an electronic package according to any one of claims 9 to 10, **characterised in that** the perforated printed circuit comprises at least one ball (12s) that is not connected to the package or at least one brazed via (12t) that is not connected to the package.

## Patentansprüche

1. Elektronisches Modul (100), das einen Stapel von n Gehäusen (10, 10a, 10b) umfasst, wobei n>1, wobei jedes Gehäuse auf der Unterseite des Körpers (11) des Gehäuses mit Anschlussperlen (12) und, mit den Perlen verbunden, mit einer gedruckten Schaltung (20, 20a, 20b) zum Verbinden des Gehäuses versehen ist, die auf der Unterseite des Körpers des Gehäuses in der Nähe der Perlen angeordnet ist und die metallisierte Bohrungen (23) aufweist, in denen sich die Perlen (12) befinden und mit denen sie verbunden sind und deren Dicke geringer ist als die der Perlen, wobei das Modul ein seitliches Element (30) zum Verbinden von durchbohrten Schaltungen miteinander umfasst und der Stapel ein unteres Gehäuse (10a) und obere Gehäuse (10b) aufweist, **dadurch gekennzeichnet, dass** die durchbohrte gedruckte Schaltung (20a) des unteren Gehäuses wenigstens eine Perle (12s) oder eine gelötete Bohrung umfasst, die nicht mit dem unteren Gehäuse (10a) verbunden und zum Verbinden eines oberen Gehäuses (10b) mit einem Verbindungssubstrat (200) des Moduls über die durchbohrte gedruckte Schaltung (20a) und das seitliche Verbindungselement (30) ausgelegt ist.

2. Elektronisches Modul nach dem vorherigen Anspruch, **dadurch gekennzeichnet, dass** die gedruckte Verbindungsschaltung des Gehäuses eine Oberfläche von im Wesentlichen derselben Abmessung hat wie die des Gehäuses.

3. Elektronisches Modul nach einem der vorherigen Ansprüche, dadurch gekenntzeichnet, dass das seitliche Element ein Metallbus ist.

4. Elektronisches Modul nach einem der Ansprüche 1 bis 2, **dadurch gekennzeichnet, dass** das seitliche Verbindungselement mit seinen durchbohrten gedruckten Schaltungen eine flexible Schaltung, "Flex" genannt, bildet.

5. Elektronisches Modul nach dem vorherigen Anspruch, **dadurch gekennzeichnet,, dass** wenigstens drei durchbohrte gedruckte Schaltungen durch eine "Flex"-Schaltung ziehharmonikaartig miteinander verbunden sind.

6. Elektronisches Modul nach einem der vorherigen Ansprüche, **dadurch gekennzeichnet, dass** es wenigstens eine Kondensatorfolie (40) umfasst, die auf und/oder unter jedem Gehäuse angeordnet ist.

7. Elektronisches Modul nach einem der vorherigen Ansprüche, **dadurch gekennzeichnet, dass** die Bohrungen gemäß einem kreisförmigen Flansch (24a) oder in zwei Teilen (24b) oder in Vierteln (24c) metallisiert sind.

8. Elektronisches Modul nach einem der vorherigen Ansprüche, **dadurch gekennzeichnet, dass** die Gehäuse Gehäuse vom BGA- oder FBGA-Typ sind.

9. Verfahren zur Herstellung eines elektronischen Gehäuses (10, 10a, 10b), das Folgendes beinhaltet:
- eine Baugruppe der Dicke E, die einen Körper (11) des Gehäuses umfasst, der auf seiner Unterseite mit Verbindungsperlen (12) der vor dem Verbinden vorbestimmten Dicke e_{b} ausgestattet ist,
- eine gedruckte Schaltung (20, 20a, 20b) zum Verbinden des Gehäuses, das eine Dicke e_{ci}, die kleiner ist als e_{b}, hat und im Wesentlichen kreisförmige metallisierte Bohrungen (23) mit einem Durchmesser dₚ aufweist, der gleich oder größer als der Durchmesser e_{b} der Perlen ist,
wobei das Verfahren einen Schritt des Lötverbindens von Verbindungsperlen (12) mit den metallisierten Bohrungen (23) der Schaltung auf eine solche Weise beinhaltet, dass die Gesamtdicke des Körpers (11) des Gehäuses, der Perlen (12) und der gedruckten Schaltung (20) nach dem Verbinden E + 10 % e_{b} nicht überschreitet, und dadurch, dass die Bohrungen gemäß einem kreisförmigen Flansch (24a) oder in zwei Teilen (24b) oder in Vierteln (24c) metallisiert werden.

10. Verfahren zur Herstellung eines elektronischen Gehäuses nach dem vorherigen Anspruch, **dadurch gekennzeichnet, dass** die gedruckte Verbindungsschaltung des Gehäuses eine Oberfläche von im Wesentlichen denselben Abmessungen hat wie die des Gehäuses.

11. Verfahren zur Herstellung eines elektronischen Gehäuses nach einem der vorherigen Ansprüche 9 bis 10, **dadurch gekennzeichnet, dass** die durchbohrte gedruckte Schaltung wenigstens eine Perle (12s) umfasst, die nicht mit dem Gehäuse verbunden ist, oder wenigstens eine gelötete Bohrung (12t), die nicht mit dem Gehäuse verbunden ist.
